# EUROPEAN PATENT APPLICATION

(11) **EP 1 956 879 A1**
(43) Date of publication of application: **13.08.2008**
(21) Application number: 07250523.3
(22) Date of filing: 09.02.2007
(51) Int. Cl.: H05K 13/04

(54) **Feeder cover**

(71) Applicant: ASUSTeK Computer Inc., Peitou, Taipei City (TW)
(72) Inventor: The designation of the inventor has not yet been filed
(74) Representative: Alexander, Thomas Bruce

(57) **Abstract**

A feeder cover used for an electronic element feeder is provided. The electronic element feeder includes a carrier band, and there is a washer on the carrier band. The feeder cover includes an elastic device, a first frame, and a second frame. The elastic device is located inside the feeder cover. The first frame has a connection apparatus for combining the feeder. The second frame combines the first frame face to face with the elastic device. The second frame includes an export head and a pressing stick. The export head is located over the carrier band. The pressing stick is formed by extending the perpendicular top portion of the second frame, and the width of the pressing stick is wider than the thickness of the second frame to press the washer. The pressing stick includes a protrusion able to press the carrier band.

## Description

### Field of the Invention

The present invention relates to an electronic element feeder for printed circuit boards, more specifically to a feeder cover for the electronic element feeders.

### Description of the Prior Art

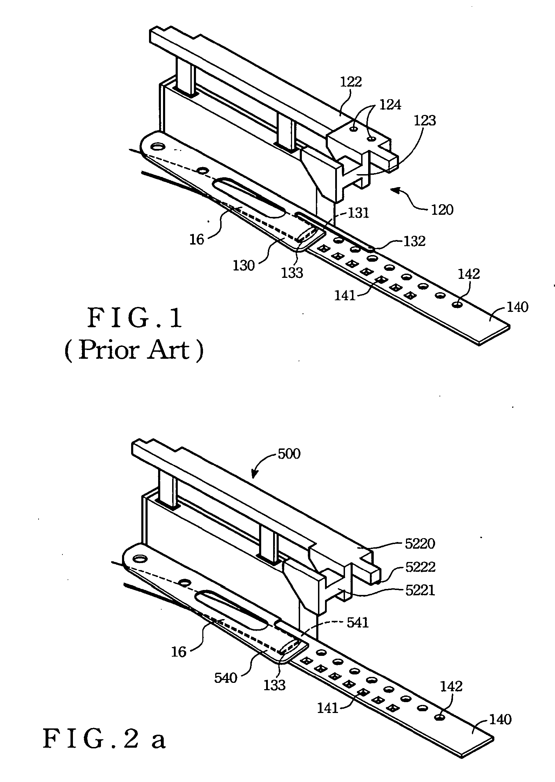

Referring to Fig 1, a fragmentary view of an electric element feeder that manufacturing by Surface Mount Technology (SMT) is shown. The electric element feeder transports the electric elements (not shown in Fig.1) for soldering the electric elements on the printed circuit board. The electric element feeder generally includes a feeder cover 120, a washer 130, and a carrier band 140.

According to Fig. 1, the carrier band 140 has plural gear apertures 142 and element holes 141 for accommodating respective electric elements. The gear apertures 142 mesh at least a gear (not shown in Fig. 1) to drive the carrier band 140. The gear is in the chink 131 of the washer 130.

In Fig.1, the top portion of the feeder cover 120 includes a pressing stick 122 and an export head 123, the export head 123 generally integrates with the pressing stick 122 by screws 124. The export head 123 prevents the carrier band 140 from poking while the electronic elements sucked by the sucker (not shown in Fig. 1). The pressing stick 122 presses the washer 130 to fix the carrier band 140 so as to deliver the electric elements steadily.

The washer 130 has a cleft 133. The cleft 133 peels the tap 16 on the carrier band 140 to expose the electric elements inside the element holes 141, and the electric elements can be sucked by the sucker for soldered on the printed circuit board.

The washer 130 has a long portion 132. When the washer 130 is used for a long time, the long portion 132 will be deformed as lift-upward. The carrier band 140 is able to fix the carrier band 140 and to deliver the electric elements steadily until the long portion 132 is deformed. When the long portion 132 is deformed, the carrier band 140 can not be fixed by the long portion 132 of the washer 130. Hence, a shaking will be occurred in the carrier band 140. The shaking results in the electric elements to be soldered in wrong positions on the printed circuit board, e.g. up side down soldered, or opposite directions soldered, and thus the yield of the products would be greatly reduced.

According to the aforesaid statement, the invention provides a feeder cover for preventing the aforesaid drawback from the deformed long portion of the washer 130 so as to increase the yield of the products.

### SUMMARY OF THE INVENTION

The object of the present invention is to provide a feeder cover of an electronic element feeder. The feeder cover has a protrusion on the washer to avoid wrong position soldered such as up side down soldered, or opposite directions soldered. The improved washer of the feeder cover of the present invention can eliminate the aforesaid drawback resulting from the use of the conventional electronic element feeder.

According to the description of the present invention, the feeder cover is used for an electronic element feeder. The electronic element feeder includes a carrier band having thereon a washer. The feeder cover of the present invention includes an elastic device, a first frame, and a second frame.

The elastic device is located inside the electronic element feeder cover. The first frame has a connection apparatus for combining the feeder.

The second frame combines the first frame face to face. The elastic device is used to combine the second frame and the first frame. The second frame includes an export head and a pressing stick.

The export head is located over the carrier band to prevent the carrier band from poking while the electronic elements sucked by the sucker.

The pressing stick is formed by extending the top portion of the second frame. Moreover, the width of the pressing stick is wider than the thickness of the second frame. The pressing stick of the present invention is for pressing the washer.

The pressing stick has a protrusion instead of the long portion of the conventional feeder cover to press the carrier band. The pressing stick can press the washer due to the second frame moved up and down relatively to the first frame, and the protrusion can press the carrier band due to the width of the pressing stick wider than the thickness of the second frame. With the improvement of the long portion of the washer, the yield is increased.

### BRIEF DESCRIPTION OF THE DRAWINGS

The foregoing aspects and many of the attendant advantages of this invention will become more readily appreciated as the same becomes better understood by reference to the following detailed description, when taken in conjunction with the accompanying drawings, wherein:

Fig.1 is a fragmentary perspective view of a conventional electronic element feeder;

Fig.2A is a fragmentary perspective view of a electronic element feeder in a preferred embodiment of the present invention;

Fig.2B is a perspective view of the feeder cover in a preferred embodiment of the present invention;

Fig.2C is a turnover and fragmentary perspective view of the pressing stick in a preferred embodiment of the present invention; and

Fig.2D is an exploded view of the feeder cover in a preferred embodiment of the present invention.

### DESCRIPTION OF THE PREFERRED EMBODIMENTS

Referring to Fig.2A, a fragmentary perspective view of a preferred electronic element feeder of the present invention is shown. The feeder cover has a carrier band 140, a washer 540, and a feeder cover 500.

Unlike the conventional washer 130 in Fig.1, the washer 540 of the present embodiment does not have a long portion 132. Therefore, the up side down soldered, or opposite directions soldered resulting from a deformed long portion 132 is eliminated. Thus, the yield of the products will be raised.

The feeder cover 500 has a pressing stick 5220 and an export head 5221 in Fig.2A. The pressing stick 5220 and the export head 5221 can be made of the same material. The pressing stick 5220 and the export head 5221 can also be united as a single piece as shown in Fig.2A. The pressing stick 5220 is used for pressing the washer 540 so as to fix the carrier band 140 for delivering the electronic elements steadily.

Furthermore, the pressing stick 5220 has a protrusion 5222 instead of the long portion 132 in conventional washer. The protrusion 5222 is used for pressing the carrier band 140. A chink 541 is formed between the washer 540 and the protrusion 5222 for depositing at least a gear (not shown in the figure). The gear meshes these gear apertures 142 for driving the carrier band 140.

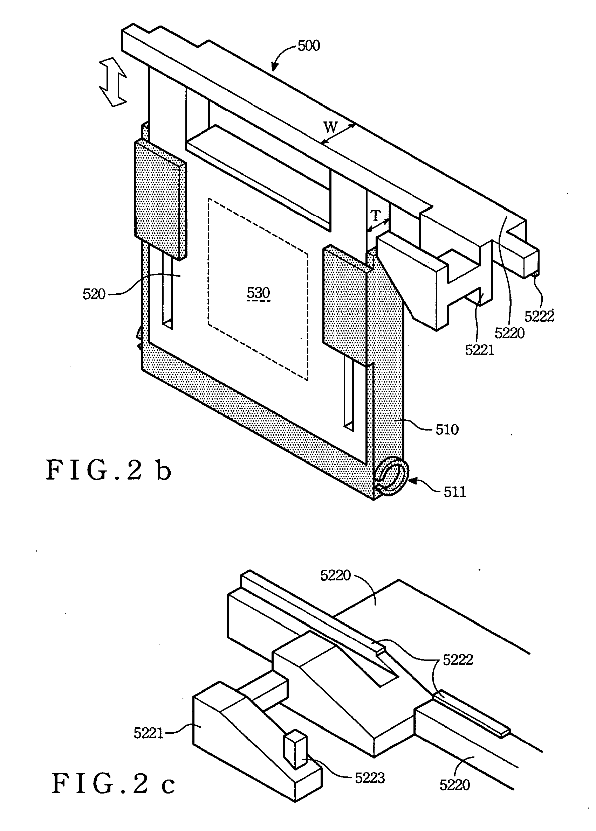

Fig.2B is a perspective view of the feeder cover 500 of the present invention. Main components of the feeder cover 500 includes at least an elastic device 530, a first frame 510 (the bias area shown in Fig.2B), and a second frame 520. The export head 5221, the pressing stick 5220, and the protrusion 5222 belong to the second frame 520. The brief description regarding to those main components is showed below.

The elastic device 530 is located inside the feeder cover 500. The first frame 510 has a connection apparatus 511 for connection with the electronic element feeder.

Moreover, the second frame 520 combines the first frame 510 face to face with the elastic device 530. The second frame 520 has elements comprising the export head 5221 and the pressing stick 5220.

The export head 5221 is located over the carrier band 140 as shown in Fig.2A. The export head 5221 prevents the carrier band 140 from poking by the sucker (not shown in the figure).

The pressing stick 5220 is formed by extending the perpendicular top portion of the second frame. Moreover, the width W of the pressing stick 5220 is wider than the thickness T of the second frame 520. The pressing stick 5220 is therefore to press the washer 540. The pressing stick 5220 includes the protrusion 5222 instead of the long portion 132 in conventional washer (see Fig.1).

The second frame 520 can move up and down relative to the first frame 510, and the elastic device 530 provides the elasticity. Further, the width W of the pressing stick 5220 is wider than the thickness T of the second frame 520. Therefore, the pressing stick 5220 is able to press the washer 540.

Fig.2C is a turnover and fragmentary perspective view of the pressing stick 5220 for explaining the detail of the protrusion 5222. The protrusion 5222 is formed from shifting the conventional long portion 132 (referring to Fig.1) onto the pressing stick 5220. Since there is no long portion 132 on the washer 540, and the protrusion 5222 has transferred onto the pressing stick 5220 instead of on the conventional long portion 132, therefore, the protrusion 5222 can used to press the carrier band 140.

Further, Fig.2C shows another preferred embodiment of the present invention. All the components are similar to that of the above embodiment, except that the export head 5221 in Fig. 2C comprises a pillar 5223 for pressing the washer 540 so the washer 540 is able to firm the carrier band 140 for delivering the electronic elements more steadily.

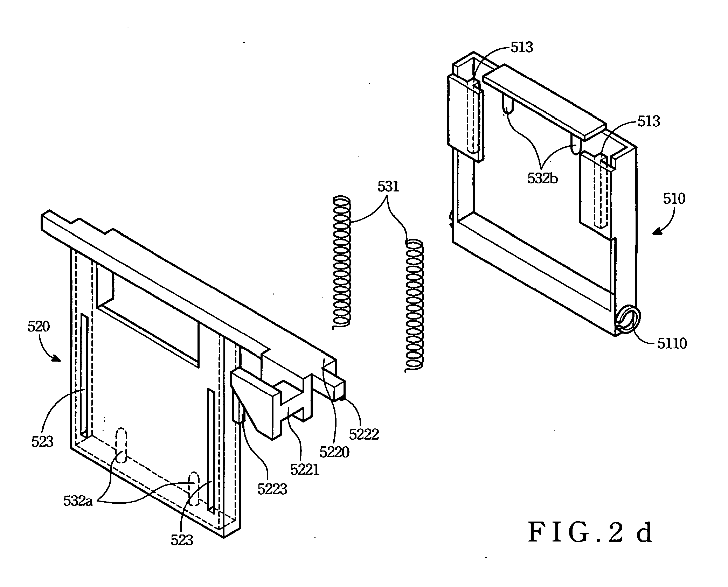

Fig.2D. is an exploded view of the feeder cover 500 in the present invention, which shows the structure of the feeder cover 500 and the combination of the first frame510 and the second frame 520. The pillar 5223 in the Fig. 2D and in the Fig. 2C can be seen together to interpret the location more clear.

In FIG.2D, the elastic device 530 is explained how to work of the present invention to make up the above function and to define the location.

In Fig.2D, the elastic device 530 includes two springs 531, and the spring-connected parts 532a and 532b. The spring-connected part 532a is located in the second frame 520 and the spring-connected part 532b is located in the first frame 510. The spring-connected part 532a and 532b are both protruding elements for joining to the two ends of the springs 531. Hence, the first frame 510 and the second frame 520 can combined to each other by the elastic device 530 .

The first frame and the second frame are connected to each other face to face, but the connection method is not clear. So, the connection method between the first frame and the second frame is explained as following in the detail by Fig. 2D.

The first frame 510 has two keys 513 and the second frame 520 has two notches 523. These notches 523 are put into these keys 513 one by one so as to combine the first frame 510 and the second frame 520 together face to face.

The first frame 510 and the second frame 520 can be both made of the same material such as plastic. Because the plastic material has inherent plasticity and toughness, the keys 513 can be pulled to fit into the notches 523. Therefore, the first frame 510 and the second frame 520 can be combined face to face.

Alternatively, the first frame 510 and the second frame 520 can also be made of metal, especially aluminum or aluminum alloy. Aluminum and aluminum alloy also have the characteristics of plastic such plasticity and toughness, hence, the keys 513 can also be pulled to fit into the notches 523. Therefore, the first frame 510 and the second frame 520 can be combined face to face.

Because of the physical character of metal is stronger than that of the plastic, hence, the feeder cover 500 can be made from metal to reduce the damage. Therefore, the online lifespan of the feeder cover 500 is prolonged. The frequency of repair or exchange of the feeder cover 500 can be lower, and thus the cost can be reduced.

The second frame 520 can be moved relatively to the first frame 510 because that the keys 513 are able to be slipped along the notches 523. Further, the pressing stick 5220 is able to press the washer 540 and the protrusion 5222 is able to press the carrier band 140.

The foresaid connection apparatus 511 can be a C-type aperture 5110 as shown in the Fig.2D. The connection apparatus 511 is used to joint with the electronic element feeder mainly. It is certain that the connection apparatus 511 has various embodiments. The C-type aperture 5110 is only one of the preferred embodiments of the connection apparatus 511. The C-type aperture 5110 is not the limited embodiment to the connection apparatus 511 here.

The elastic device 530 shown in Fig.2D as well as the combination of the first frame 510 and the second frame 520 are the preferred embodiments of the present invention. The elastic device 530 can include only a spring 531, or more than three springs 531, etc. The number of the springs 531 is not limited to the preferred embodiment of the elastic device 530 here. Furthermore, a washer can be used instead of the spring 531.

The feeder cover of the present invention can improve the low yield of the conventional feeder cover. Furthermore, the preferable embodiment of the feeder cover in the present invention is made by metal. Therefore, the online lifespan of the feeder cover is prolonged, the frequency of repair or exchange can be lower, and thus the cost for the feeder cover can be reduced.

As is understood by a person skilled in the art, the foregoing preferred embodiment of the present invention is an illustration of the present invention rather than limiting thereon. It is intended to cover various modifications and similar arrangements included within the spirit and scope of the appended claims, the scope of which should be accorded the broadest interpretation so as to encompass all such modifications and similar structure.

## Claims

1. A feeder cover used in an electronic element feeder having a carrier band with a washer thereon, the feeder cover comprising:
an elastic device locating inside the feeder cover;
a first frame having a connection element to connect the electronic element feeder; and
a second frame, which combined with the first frame face to face by the elastic device, the second frame further including:
an export head locating over the carrier band; and
a pressing stick formed by extending perpendicular top portion of the second frame, and the width of the pressing stick is wider than the thickness of the second frame to press the washer; the pressing stick further including a protrusion to press the carrier band.

2. The feeder cover according to claim 1, further including a chink formed between the protrusion and the washer for accommodating at least a gear.

3. The feeder cover according to claim 1, wherein the export head has a pillar for pressing the washer.

4. The feeder cover according to claim 1, wherein the first frame and the second frame are made of the same material.

5. The feeder cover according to claim 1, wherein the elastic device has at least a spring.

6. The feeder cover according to claim 1, wherein the connection apparatus includes at least a C-type aperture.
